# FASCICULE DE BREVET EUROPEEN

(11) **EP 2 784 522 B1**
(45) Date de publication et mention de la délivrance du brevet: **22.08.2018**
(21) Numéro de dépôt: 14155424.6
(22) Date de dépôt: 17.02.2014
(51) Int. Cl.: H02J 13/00, H02J 3/14, H03K 5/08

(54) **Dispositif pour la détermination d'un mode de fonctionnement d'un appareil électrique**
Vorrichtung für die Bestimmung eines Betriebsmodus eines elektrischen Geräts
Device for determining an operating mode of an electric apparatus

(30) Priorité: 26.03.2013 FR 1352688
(43) Date de publication de la demande: 01.10.2014
(73) Titulaire: Somfy SAS, 74300 Cluses (FR)
(72) Inventeur: Bruno, Serge, 74460 Marnaz (FR)
(74) Mandataire: Verriest, Philippe

(56) Documents cités:
- EP-A1- 0 952 680
- FR-A1- 2 867 919
- US-A1- 2010 314 942

## Description

La présente invention concerne un dispositif et un procédé pour la détermination d'un mode de fonctionnement d'un appareil électrique, et un ensemble pour la gestion de données de fonctionnement d'au moins un appareil électrique.

On connait, par le document FR2932030A1, un ensemble pour la gestion de la consommation d'un appareil électrique.

L'ensemble comporte une station centrale et un dispositif connectant un appareil électrique à une prise secteur communicant avec la station centrale.

Le dispositif est équipé d'un module d'alimentation permettant de transformer une tension secteur en une tension d'alimentation.

Le dispositif est équipé d'un module de communication apte à transmettre une succession de messages à la station centrale lorsqu'il est alimenté par le module d'alimentation. Le message contient un identifiant du dispositif et une quantité de courant ayant traversé le dispositif.

Lorsque le réseau électrique est opérationnel, le module d'alimentation alimente le module de communication et ce dernier transmet la succession de messages à la station centrale.

Lorsque le réseau électrique est en panne, le module d'alimentation n'alimente plus le module de communication et ce dernier ne transmet plus de messages à la station centrale.

Ainsi, la station centrale peut détecter une panne du réseau électrique ou encore calculer la consommation de l'appareil électrique.

Un inconvénient d'un tel ensemble est qu'il ne permet de gérer qu'une donnée de fonctionnement de l'appareil électrique, à savoir une consommation.

L'invention vise à remédier à cet inconvénient.

Le document US 2010/0314942 A1 décrit un procédé qui comprend la détermination d'un prélèvement de courant désiré pour une pluralité de charges connectées à un réseau électrique, chacune de la pluralité de charges étant connectée au réseau électrique par une commande d'alimentation de charge et étant apte à obtenir une quantité désirée d'énergie à partir du réseau dans une période de temps désirée. L'invention concerne un dispositif pour la détermination d'un mode de fonctionnement d'un appareil électrique, caractérisé en ce qu'il comporte :
- des moyens de connexion agencés pour connecter l'appareil électrique à une prise secteur de sorte qu'un courant puisse circuler entre la prise secteur et l'appareil électrique ;
- un module de mesure configuré pour fournir un signal de tension rectangulaire dont le rapport cyclique est fonction de la forme du courant circulant entre la prise secteur et l'appareil électrique, et notamment de la géométrie et/ou de l'amplitude du courant ; et
- un module de contrôle connecté au module de mesure et configuré pour déterminer le rapport cyclique du signal de tension et établir une correspondance entre au moins un rapport cyclique du signal de tension fourni par le module de mesure et un indicateur d'un mode de fonctionnement.

La forme du courant est définie par sa géométrie, par exemple sinusoïdale, rectangulaire, carrée, triangulaire, ou encore en dent de scie, et/ou par son amplitude. Le terme « amplitude » doit s'entendre comme synonyme «d'amplitude crête à crête».

La géométrie du courant circulant entre la prise secteur et l'appareil électrique est classiquement sinusoïdale. L'amplitude du courant circulant entre la prise secteur et l'appareil électrique dépend du mode de fonctionnement mis en oeuvre par l'appareil électrique.

Par exemple, lorsque l'appareil électrique est en mode marche, l'amplitude du courant est élevée. Lorsque l'appareil électrique est en mode veille, l'amplitude du courant est pratiquement nulle. Lorsque l'appareil électrique est en mode arrêt, l'amplitude du courant est nulle.

Le module de mesure délivre un signal, en particulier un signal rectangulaire, dont le rapport cyclique est fonction de la forme du courant circulant entre la prise secteur et l'appareil électrique. Le rapport cyclique est alors fonction du mode de fonctionnement de l'appareil.

Le module de contrôle établit une correspondance entre des rapports cycliques et des indicateurs de modes de fonctionnement. Le module de contrôle permet en effet de distinguer plusieurs modes de fonctionnement de l'appareil électrique, ceux-ci ayant notamment été appris au préalable ou étant issus du contenu d'une base de données fournie au dispositif.

Le dispositif selon l'invention est avantageux en ce qu'il permet de déterminer le mode de fonctionnement mis en oeuvre par l'appareil électrique parmi des modes de fonctionnement dont les indicateurs auront été préalablement mémorisés.

Le dispositif selon l'invention est en outre avantageux en ce qu'il permet de distinguer ou différencier des modes de fonctionnement avec des types de consommation très proches, par exemple un mode veille et un mode arrêt, par rapport à une plage globale de consommation sur les différents modes de fonctionnement.

La connaissance du mode de fonctionnement de l'appareil permet de déduire une pluralité de données de fonctionnement de l'appareil électrique, telles que :
- la consommation de l'appareil électrique ;
- la durée pendant laquelle un mode de fonctionnement est mis en oeuvre par l'appareil électrique ;
- un changement de mode de fonctionnement par l'appareil électrique;
- un nombre de mises en oeuvre d'un mode de fonctionnement par l'appareil électrique ; ou
- une annonce de fin de mise en oeuvre d'un mode de fonctionnement par l'appareil électrique.

Le dispositif selon l'invention peut comporter une ou plusieurs des caractéristiques suivantes.

Suivant une caractéristique, le dispositif comporte un module de communication connecté au module de contrôle et configuré pour transmettre l'indicateur du mode de fonctionnement, par exemple à un module de communication d'une station centrale.

Ainsi, l'indicateur du mode de fonctionnement peut être partagé entre le dispositif et une station centrale, telle qu'un ordinateur, et éventuellement une station périphérique, telle qu'un téléphone, une tablette, ou tout autre support multimédia.

Avantageusement, le dispositif comporte un module d'alimentation configuré pour alimenter le module de mesure, le module de contrôle et/ou le module de communication avec une tension déterminée, le module d'alimentation étant agencé pour être connecté en série à la prise secteur et l'appareil électrique.

Ainsi, l'appareil électrique fonctionne à la puissance délivrée par la prise secteur à laquelle a été retranchée la puissance prélevée par le module d'alimentation et qui est non perceptible du point de vue de l'utilisateur ou de l'appareil.

De préférence, les moyens de connexion comprennent :
- des première et seconde bornes d'entrée agencées pour être connectées à des bornes de la prise secteur, de préférence à une borne de phase et à une borne de neutre ; et
- des première et seconde bornes de sortie agencées pour être connectées à des bornes de l'appareil électrique ; et
le module d'alimentation comprend :
- un étage de puissance connecté à la première borne d'entrée et à la première borne de sortie des moyens de connexion pour créer une différence de potentiel entre ces bornes et pourvu d'au moins deux diodes ; et
- un étage de redressement capacitif connecté à la première borne d'entrée et à la première borne de sortie et pourvu d'au moins une diode et d'un condensateur.

La tension alimentant le module de mesure, le module de contrôle et/ou le module de communication est prise aux bornes du condensateur de l'étage de redressement capacitif. Un tel agencement permet de ne prélever aucun courant lorsque l'appareil électrique est en mode arrêt, et sans engendrer de consommation additionnelle.

Suivant une caractéristique, le module de mesure comprend :
- un détecteur de courant, tel qu'un optocoupleur, présentant un émetteur et un récepteur ;
- un étage d'émission connecté à la première borne d'entrée et la première borne de sortie des moyens de connexion,
   l'étage d'émission étant pourvu d'au moins une résistance et de l'émetteur du détecteur de courant,
   l'émetteur du détecteur de courant étant conçu pour émettre uniquement lorsque le courant circulant dans l'étage d'émission est supérieur à un seuil déterminé ; et
- un étage de réception comprenant au moins une résistance et le récepteur du détecteur de courant,
le récepteur du détecteur de courant étant agencé pour commuter dans un état passant lorsque l'émetteur émet et pour commuter dans un état bloquant sinon.

En condition d'utilisation, l'étage d'émission du module de mesure est connecté en série à l'appareil électrique et à la prise secteur.

Un tel agencement permet de ne prélever aucun courant lorsque l'appareil électrique est en mode arrêt, et donc de n'engendrer aucune consommation additionnelle.

La résistance de l'étage d'émission permet de définir la plage d'amplitudes du courant susceptible de circuler dans l'étage d'émission, et par conséquent, de définir la plage de rapports cycliques exploitables.

De préférence, l'étage de réception du module de mesure est connecté en parallèle au condensateur de l'étage de redressement capacitif du module d'alimentation.

Suivant une possibilité, le dispositif comporte des moyens de fixation inamovible à l'appareil électrique.

Ainsi, en condition d'utilisation le dispositif et l'appareil électrique sont indissociables l'un de l'autre.

Le module de contrôle du dispositif peut être paramétré définitivement lors de la fixation du dispositif à un appareil électrique. Le module de contrôle établit alors définitivement une correspondance entre des rapports cycliques du signal fourni par le module de mesure et des indicateurs de modes de fonctionnement.

Suivant une possibilité, le dispositif comporte des moyens de fixation amovible à l'appareil électrique.

Ainsi, en condition d'utilisation le dispositif et l'appareil électrique sont dissociables l'un de l'autre.

Le module de contrôle du dispositif peut être paramétré provisoirement lors de la fixation du dispositif à l'appareil électrique. Le module de contrôle établit alors provisoirement une correspondance entre des rapports cycliques du signal fourni par le module de mesure et des indicateurs de modes de fonctionnement.

L'invention concerne également un ensemble pour la gestion de données de fonctionnement d'au moins un appareil électrique, caractérisé en ce qu'il comporte :
- un dispositif tel que présenté ci-avant ; et
- une station centrale comprenant :
   - un module de communication configuré pour communiquer avec le module de communication du dispositif et pour recevoir au moins un indicateur ; et
   - un module de contrôle connecté au module de communication et configuré pour déterminer au moins une donnée de fonctionnement de l'appareil électrique à partir dudit au moins un indicateur reçu.

Avantageusement, le module de communication de la station centrale est configuré pour transmettre un message d'alerte à un module de communication d'une station périphérique en réponse à un événement particulier.

L'événement particulier peut être une fin de mise en oeuvre d'un mode de fonctionnement, une durée anormalement élevée de mise en oeuvre d'un mode de fonctionnement, ou une consommation anormalement élevée.

L'événement particulier peut encore être la réception d'un indicateur ne correspondant à aucun mode de fonctionnement de l'appareil électrique

L'événement particulier peut enfin être l'expiration d'un compte à rebours (ou « time out »), le compte à rebours étant déclenché lors d'un changement de mode de fonctionnement. Ainsi, il est possible de distinguer une pause pendant la mise en oeuvre d'un mode de fonctionnement d'une mise en oeuvre du mode arrêt.

L'invention concerne enfin un procédé pour la détermination d'un mode de fonctionnement d'un appareil électrique, caractérisé en ce qu'il comporte les étapes consistant à :
- fournir un signal de tension rectangulaire dont le rapport cyclique est fonction de la forme d'un courant circulant entre une prise secteur et l'appareil électrique, et notamment de la géométrie et/ou de l'amplitude du courant ; et
- déterminer le rapport cyclique du signal de tension et établir une correspondance entre au moins un rapport cyclique du signal de tension fourni et un indicateur d'un mode de fonctionnement ; et
- fournir cet indicateur.

Suivant une caractéristique, le procédé comporte une étape consistant à mémoriser, définitivement ou provisoirement, un ensemble de rapports cycliques et d'indicateurs de modes de fonctionnement correspondants.

Suivant une autre caractéristique, le procédé comporte les étapes consistant à :
- recevoir une requête en mémorisation d'un indicateur d'un mode de fonctionnement de l'appareil électrique ;
- mettre en oeuvre le mode de fonctionnement de l'appareil électrique ;
- fournir un signal de tension dont le rapport cyclique est fonction de la forme du courant circulant entre l'appareil électrique et la prise secteur ; et
- établir une correspondance entre un indicateur du mode de fonctionnement et le rapport cyclique; et
- mémoriser le rapport cyclique et l'indicateur du mode de fonctionnement correspondant.

L'invention sera mieux comprise à l'aide de la description qui suit, en référence au dessin schématique annexé représentant, à titre d'exemple, un dispositif pour la détermination d'un mode de fonctionnement d'un appareil électrique selon l'invention.
Figure 1 en est une représentation schématique ;

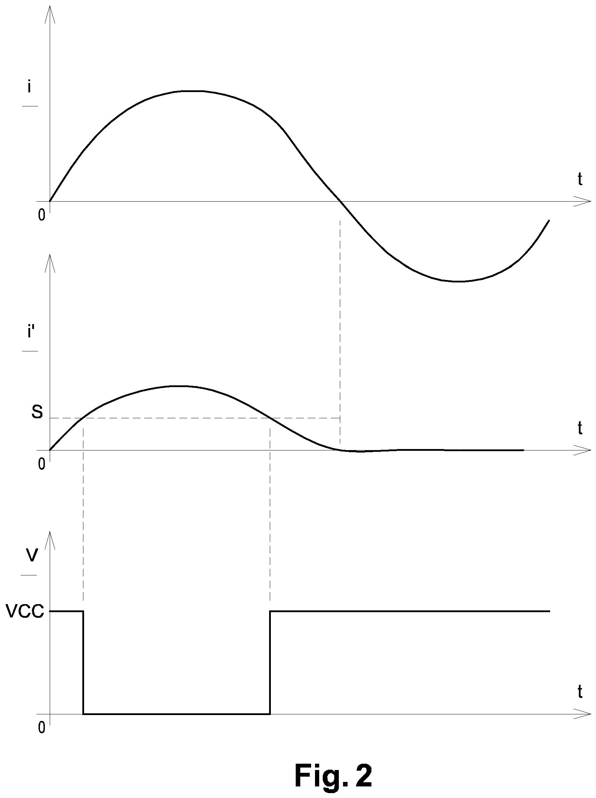

Figure 2 représente des signaux traités par le dispositif de la figure 1 ;
Figure 3 est une représentation schématique d'un ensemble pour la gestion de données de fonctionnement d'un appareil électrique comportant le dispositif de la figure 1 ; et
Figure 4 est un organigramme d'un procédé de paramétrage du dispositif de la figure 1

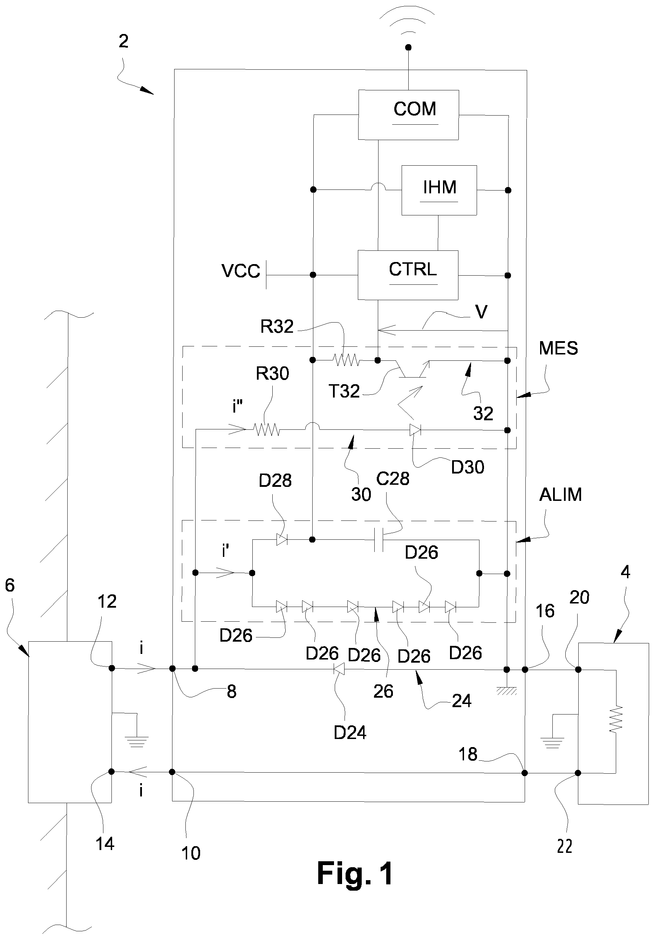

La figure 1 représente un dispositif 2 pour la détermination d'un mode de fonctionnement d'un appareil électrique 4.

Le dispositif 2 comporte des moyens de connexion agencés pour connecter l'appareil électrique 4 à une prise secteur 6, par exemple une prise murale dans une habitation, de sorte qu'un courant i puisse circuler entre l'appareil électrique 4 la prise secteur 6. Le courant i est donc fourni par le réseau électrique à une fréquence d'environ 50Hz avec une tension correspondante du secteur de l'ordre de 230V.

Les moyens de connexion comprennent des bornes d'entrée 8, 10 connectée respectivement à des bornes de phase 12 et de neutre 14 de la prise secteur 6.

Les moyens de connexion comprennent des bornes de sortie 16, 18 connectées à des bornes 20, 22 de l'appareil électrique 4. La borne 16 est directement connectée à la masse électrique du dispositif 2. Les bornes d'entrée et de sortie des moyens de connexion forment les bornes du dispositif 2.

Le dispositif 2 comporte une branche 24 agencée pour conduire le courant i lors des alternances négatives. La branche 24 est connectée à la borne d'entrée 8 et à la borne de sortie 16. La branche est pourvue d'une diode D24.

Le dispositif 2 comporte un module d'alimentation ALIM agencé pour conduire une première fraction i' du courant i lors des alternances positives. Le module d'alimentation ALIM est connecté en série à l'appareil électrique 4 et la prise secteur 6. Le module d'alimentation ALIM fournit une tension d'alimentation VCC.

Le module d'alimentation ALIM comprend un étage de puissance 26 connecté à la borne d'entrée 8 et à la borne de sortie 16. L'étage de puissance 26 est pourvu de six diodes de puissance D26, permettant de créer une différence de potentiel entre la borne d'entrée 8 et la borne de sortie 6 lors des alternances positives du courant i.

Le module d'alimentation ALIM comprend également un étage de redressement capacitif 28 connecté à la borne d'entrée 8 et à la borne de sortie 16. L'étage de redressement capacitif 28 est pourvu d'une diode D28 et d'un condensateur C28. La tension d'alimentation VCC est fournie aux bornes du condensateur C28.

Le dispositif 2 comporte un module de mesure MES configuré pour fournir une tension V rectangulaire dont le rapport cyclique est fonction de la forme du courant i, et en particulier de l'amplitude du courant i.

Le module de mesure MES comprend un étage d'émission 30 agencé pour conduire une deuxième fraction i" du courant i lors des alternances positives. L'étage d'émission 30 est connecté à la borne d'entrée 8 et la borne de sortie 16. L'étage d'émission 30 est pourvu d'une résistance R30 et d'un émetteur D30 appartenant à un optocoupleur.

L'émetteur D30 est conçu pour émettre un rayonnement lorsque le courant i" circulant dans l'étage d'émission 30 est supérieur à un seuil S déterminé.

Le module de mesure MES comprend également un étage de réception 32 connecté aux bornes du condensateur C28 de manière à être alimenté par la tension VCC. L'étage de réception 32 est pourvu d'une résistance R32 et d'un récepteur T32 de l'optocoupleur.

Le récepteur T32 est conçu pour commuter dans un état passant lorsque l'émetteur D30 émet et pour commuter dans un état bloquant sinon.

La tension V est fournie aux bornes du récepteur T32. Lorsque le récepteur T32 est passant, la tension V est nulle. Lorsque le récepteur est bloquant, la tension V est égale à VCC.

Le dispositif 2 comporte un module de contrôle CTRL connecté aux bornes du condensateur C28 de manière à être alimenté par la tension VCC. Le module de contrôle CTRL est également connecté au récepteur T32 de manière à pouvoir déterminer le rapport cyclique de la tension V.

Le module de contrôle CTRL établit une correspondance entre des rapports cycliques de la tension V et des modes de fonctionnement de l'appareil électrique 4 et est configuré pour fournir un indicateur correspondant au mode de fonctionnement identifié par le rapport cyclique déterminé.

Le dispositif 2 comporte un module de communication COM connecté aux bornes du condensateur C28 de manière à être alimenté par la tension VCC. Le module de communication COM est connecté au module de contrôle CTRL de manière à pouvoir transmettre des messages contenant un indicateur du mode de fonctionnement fourni par le module de contrôle CTRL et un identifiant propre au dispositif 2.

Le dispositif 2 comporte enfin une interface homme-machine IHM permettant de paramétrer ce dispositif 2. Cette interface IHM est notamment associée au module de contrôle CTRL. Elle peut être ne comporter qu'une diode lumineuse et un ou plusieurs boutons, notamment un bouton de mise en mode de programmation et un bouton de sélection d'indicateur de mode de fonctionnement. La diode lumineuse peut notamment présenter plusieurs couleurs, qui pourront être associées chacune à un mode de fonctionnement d'un appareil.

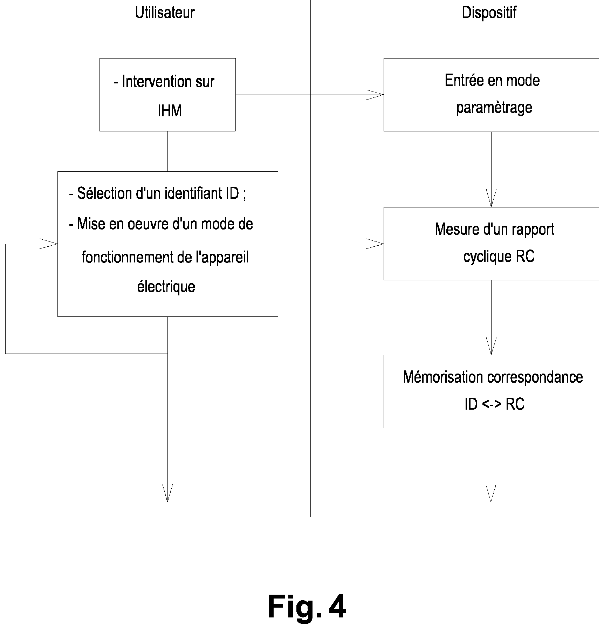

Un procédé de paramétrage du dispositif 2 est maintenant décrit en référence à la figure 4.

Suivant une première possibilité, le dispositif 2 est fixé de manière amovible à l'appareil électrique 4. Le dispositif 2 est paramétré provisoirement par un utilisateur lorsque le dispositif est associé à un appareil électrique 4.

A cette fin, l'utilisateur intervient manuellement sur l'interface homme-machine du dispositif pour le faire entrer dans un mode de paramétrage, notamment il sélectionne un premier indicateur.

Le dispositif est alors en attente d'un mode de fonctionnement correspondant.

L'utilisateur intervient ensuite au niveau de l'appareil associé pour mettre en oeuvre un des modes de fonctionnement de l'appareil.

Lorsque le mode de fonctionnement de l'appareil électrique 4 est mis en oeuvre, le courant i circule entre l'appareil électrique 4 et la prise secteur 6. En réponse, le module de mesure MES fournit la tension V dont le rapport cyclique est fonction de la forme du courant i, e en particulier de l'amplitude du courant i.

Le module de contrôle CTRL détermine le rapport cyclique de la tension V et établit une correspondance entre l'indicateur sélectionné précédemment et le mode de fonctionnement déterminé.

Enfin, le module de contrôle CTRL mémorise le rapport cyclique et l'indicateur du mode de fonctionnement correspondant dans une mémoire réinscriptible.

Ces opérations peuvent être répétées pour mémoriser plusieurs indicateurs de modes de fonctionnement de l'appareil électrique 4.

De manière alternative, le dispositif 2 peut être capable de rechercher automatiquement et d'enregistrer les différents modes de fonctionnements mis en oeuvre par l'appareil électrique 4 et leur enchaînement.

Ainsi, le fonctionnement de l'appareil électrique 4 peut être défini par l'enchaînement de ses modes de fonctionnement. Le module de contrôle CTRL mémorise la séquence de différents rapports cycliques, et peut transmettre une alarme si le fonctionnement s'écarte de cette séquence préalablement enregistrée.

Suivant une seconde possibilité, le dispositif 2 est fixé de manière inamovible à l'appareil électrique 4. Le dispositif 2 est alors paramétré définitivement par un opérateur en phase de conception.

Par exemple, l'opérateur met en oeuvre chacun des modes de fonctionnement de l'appareil électrique 4 et effectue un relevé de rapports cycliques du signal fourni par le module de mesure MES d'un dispositif étalon.

Puis, à chaque rapport cyclique est attribué un indicateur du mode de fonctionnement correspondant.

Enfin, les rapports cycliques et les indicateurs de mode de fonctionnement correspondant sont enregistrés dans une mémoire non réinscriptible du dispositif 2.

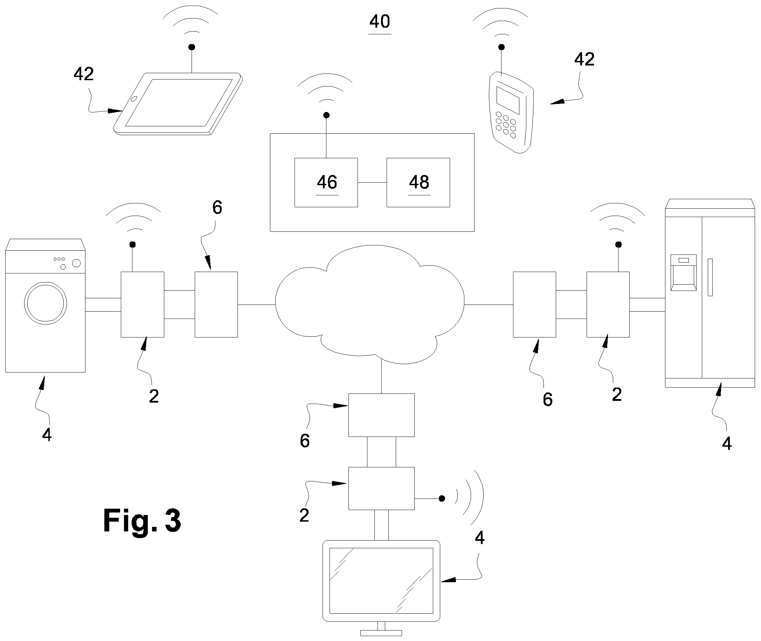

La figure 3 représente un ensemble 40 pour la gestion de données de fonctionnement des appareils électriques 4, tels qu'une machine à laver, une télévision et un réfrigérateur. L'invention s'applique également pour les appareils électriques liés au bâtiment, par exemple les volets, les protections solaires, les portes ou portails motorisés, ou encore l'éclairage ou les appareils de chauffage ou de climatisation.

L'ensemble 40 comporte des dispositifs 2 associés aux appareils électriques 4.

L'ensemble 40 comporte des stations périphériques 42, telles qu'un téléphone et une tablette. Chaque station périphérique 42 comporte un module de communication (non représenté).

L'ensemble 40 comporte une station centrale 44, telle qu'un ordinateur. La station centrale 44 comprend un module de communication 46 et un module de contrôle 48.

Le module de communication 46 est apte à recevoir les messages transmis par un module de communication COM d'un dispositif 2. Il est rappelé qu'un message contient au moins un identifiant propre au dispositif 2 et un indicateur d'un mode de fonctionnement mis en oeuvre par le dispositif 2.

Le module de contrôle 48 est apte à traiter les messages reçus par le module de communication 46 et à déterminer des données de fonctionnement de chaque appareil électrique 4 à partir du contenu de ces messages.

Une donnée de fonctionnement d'un appareil électrique 4 est par exemple :
- une durée de mise en oeuvre d'un mode de fonctionnement par l'appareil électrique 4 ;
- une consommation de l'appareil électrique 4 ;
- un changement de mode de fonctionnement de l'appareil électrique 4 ;
- un nombre de mises en oeuvre d'un mode de fonctionnement par l'appareil électrique 4 ; ou
- une annonce de fin de mise en oeuvre d'un mode de fonctionnement par l'appareil électrique 4.

Le module de contrôle 48 peut déterminer la durée de mise en oeuvre d'un mode de fonctionnement par un appareil électrique 4 en mesurant le temps séparant la réception de deux messages provenant de cet appareil électrique 4 et contenant un même indicateur d'un mode de fonctionnement.

Le module de contrôle 48 peut déterminer la consommation électrique d'un appareil électrique 4 en connaissant la durée de mise en oeuvre d'un mode de fonctionnement mis en oeuvre par l'appareil électrique 4 et en connaissant la consommation par unité de temps pour ce mode de fonctionnement.

La consommation par unité de temps pour chaque mode de fonctionnement de l'appareil électrique 4 est à cet effet préalablement renseignée auprès de la station centrale 46, notamment en utilisant les informations fournies sur les notices des appareils ou un appareil de mesure de puissance rapporté.

Le module de contrôle 48 peut détecter un changement de mode de fonctionnement mis en oeuvre par un appareil électrique 4 en recevant deux messages successifs provenant de l'appareil électrique 4 et contenant des indicateurs de modes fonctionnement distincts.

Le module de contrôle 48 peut calculer le nombre de mises en oeuvre d'un mode de fonctionnement par un appareil électrique 4 en comptabilisant le nombre de changements de mode de fonctionnement vers un mode de fonctionnement déterminé.

Le module de contrôle 48 peut détecter une annonce de fin de mise en oeuvre d'un mode de fonctionnement par un appareil électrique 4 en recevant une succession de messages provenant de l'appareil électrique 4, ces messages contenant un même indicateur d'un mode de fonctionnement.

Le module de communication 46 de la station centrale 44 est enfin configuré pour transmettre un message d'alerte aux modules de communication des stations périphériques 42 en réponse à un événement particulier. Un événement particulier peut être :
- une fin de mise en oeuvre d'un mode de fonctionnement par un appareil électrique 4,
- une durée anormalement élevée de mise en oeuvre d'un mode de fonctionnement par un appareil électrique 4 ;
- une réception d'un indicateur d'un mode de fonctionnement et/ou d'un identifiant d'un dispositif inconnus ; ou
- une expiration d'un compte à rebours (ou « time out »), le compte à rebours étant déclenché lors d'un changement de mode de fonctionnement de l'appareil électrique 4.

Comme il va de soi, l'invention ne se limite pas aux seules formes d'exécution présentées ci-avant, elle en embrasse au contraire toutes les variantes de réalisation.

## Revendications

1. Dispositif (2) pour la détermination d'un mode de fonctionnement d'un appareil électrique (4), **caractérisé en ce qu'**il comporte :
- des moyens de connexion agencés pour connecter l'appareil électrique (4) à une prise secteur (6) de sorte qu'un courant (i) puisse circuler entre la prise secteur (6) et l'appareil électrique (4) ;
- un module de mesure (MES) configuré pour fournir un signal de tension (V) rectangulaire dont le rapport cyclique est fonction de la forme du courant (i) circulant entre la prise secteur (6) et l'appareil électrique (4), et notamment de la géométrie et/ou de l'amplitude du courant (i); et
- un module de contrôle (CTRL) connecté au module de mesure (MES) et configuré pour déterminer le rapport cyclique du signal de tension (V) et établir une correspondance entre au moins un rapport cyclique du signal de tension (V) fourni par le module de mesure (MES) et un indicateur d'un mode de fonctionnement.

2. Dispositif (2) selon la revendication 1, **caractérisé en ce qu'**il comporte un module de communication (COM) connecté au module de contrôle (CTRL) et configuré pour transmettre l'indicateur du mode de fonctionnement, par exemple à un module de communication d'une station centrale (44).

3. Dispositif (2) selon l'une quelconque des revendications 1 à 2, **caractérisé en ce qu'**il comporte un module d'alimentation (ALIM) configuré pour alimenter le module de mesure (MES), le module de contrôle (CTRL) et/ou le module de communication (COM) avec une tension (VCC) déterminée, le module d'alimentation (ALIM) étant agencé pour être connecté en série à la prise secteur (6) et l'appareil électrique (4).

4. Dispositif (2) selon la revendication 3, **caractérisé en ce que** les moyens de connexion comprennent :
- des première et seconde bornes d'entrée (8, 10) agencées pour être connectées à des bornes (12, 14) de la prise secteur (6), de préférence à une borne de phase (12) et à une borne de neutre (14) ; et
- des première et seconde bornes de sortie (16, 18) agencées pour être connectées à des bornes (20, 22) de l'appareil électrique (4) ; et
**en ce que** le module d'alimentation (ALIM) comprend :
- un étage de puissance (26) connecté à la première borne d'entrée (8) et à la première borne de sortie (16) des moyens de connexion pour créer une différence de potentiel entre ces bornes (8, 16) et pourvu d'au moins deux diodes (D26) ; et
- un étage de redressement capacitif (28) connecté à la première borne d'entrée (8) et à la première borne de sortie (16) et pourvu d'au moins une diode (D28) et d'un condensateur (C28).

5. Dispositif (2) selon la revendication 4, **caractérisé en ce que** le module de mesure (MES) comprend :
- un détecteur de courant, tel qu'un optocoupleur, présentant un émetteur (D30) et un récepteur (T32) ;
- un étage d'émission (30) connecté à la première borne d'entrée (8) et la première borne de sortie (16) des moyens de connexion,
l'étage d'émission (30) étant pourvu d'au moins une résistance (R30) et de l'émetteur (D30) du détecteur de courant,
l'émetteur (D30) du détecteur de courant étant conçu pour émettre uniquement lorsque le courant (i') circulant dans l'étage d'émission (30) est supérieur à un seuil déterminé (S); et
- un étage de réception (32) comprenant au moins une résistance (R32) et le récepteur (T32) du détecteur de courant,
le récepteur (T32) du détecteur de courant étant agencé pour commuter dans un état passant lorsque l'émetteur (D32) émet et pour commuter dans un état bloquant sinon.

6. Dispositif (2) selon las revendications 4 et 5, **caractérisé en ce que** l'étage de réception (32) du module de mesure (MES) est connecté en parallèle au condensateur (C28) de l'étage de redressement capacitif (28) du module d'alimentation (ALIM).

7. Dispositif (2) selon l'une quelconque des revendications 1 à 6, **caractérisé en ce qu'**il comporte des moyens de fixation inamovible à l'appareil électrique (4).

8. Dispositif (2) selon l'une quelconque des revendications 1 à 7, **caractérisé en ce qu'**il comporte des moyens de fixation amovible à l'appareil électrique (4).

9. Ensemble (40) pour la gestion de données de fonctionnement d'au moins un appareil électrique (4), **caractérisé en ce qu'**il comporte :
- un dispositif (2) selon l'une quelconque des revendications 2 à 8 associé audit appareil électrique ; et
- une station centrale (44) comprenant :
• un module de communication (46) configuré pour communiquer avec le module de communication (COM) du dispositif (2) et pour recevoir au moins un indicateur ; et
• un module de contrôle (48) connecté au module de communication (46) et configuré pour déterminer au moins une donnée de fonctionnement de l'appareil électrique (4) à partir dudit au moins un indicateur reçu.

10. Ensemble (40) selon la revendication 9, **caractérisé en ce que** le module de communication (46) de la station centrale est configuré pour transmettre un message d'alerte à un module de communication d'une station périphérique (42) en réponse à un événement particulier.

11. Procédé pour la détermination d'un mode de fonctionnement d'un appareil électrique (4), **caractérisé en ce qu'**il comporte les étapes consistant à :
- fournir un signal de tension (V) rectangulaire dont le rapport cyclique est fonction de la forme d'un courant (i) circulant entre une prise secteur (6) et l'appareil électrique (4), et notamment de la géométrie et/ou de l'amplitude du courant (i); et
- déterminer le rapport cyclique du signal de tension (V) et établir une correspondance entre au moins un rapport cyclique du signal de tension (V) fourni et un indicateur d'un mode de fonctionnement ; et
- fournir cet indicateur.

12. Procédé selon la revendication 11, **caractérisé en ce qu'**il comporte une étape consistant à mémoriser, définitivement ou provisoirement, un ensemble de rapports cycliques et d'indicateurs de modes de fonctionnement correspondants.

13. Procédé selon la revendication 12, **caractérisé en ce qu'**il comporte les étapes consistant à :
- recevoir une requête en mémorisation d'un indicateur d'un mode de fonctionnement de l'appareil électrique ;
- mettre en oeuvre le mode de fonctionnement de l'appareil électrique ;
- fournir un signal de tension dont le rapport cyclique est fonction de la forme du courant (i) circulant entre l'appareil électrique (4) et la prise secteur (6) ; et
- établir une correspondance entre un indicateur du mode de fonctionnement et le rapport cyclique; et
- mémoriser le rapport cyclique et l'indicateur du mode de fonctionnement correspondant.

## Patentansprüche

1. Vorrichtung (2) zur Bestimmung eines Betriebsmodus eines elektrischen Geräts (4), **dadurch gekennzeichnet, dass** es Folgendes umfasst:
- Verbindungsmittel, die angeordnet sind, um das elektrische Gerät (4) mit einer Steckdose (6) zu verbinden, so dass ein Strom (i) zwischen der Steckdose (6) und dem elektrischen Gerät (4) zirkulieren kann,
- ein Messmodul (MES), das konfiguriert ist, um ein Rechteckspannungssignal (V) zu liefern, dessen zyklisches Verhältnis eine Funktion der Form des Stroms (i) ist, der zwischen der Steckdose (6) und dem elektrischen Gerät (4) zirkuliert, und insbesondere der Geometrie und/oder der Amplitude des Stroms (i); und
- ein Steuermodul (CTRL), das mit dem Messmodul (MES) verbunden und konfiguriert ist, um das zyklische Verhältnis des Spannungssignals (V) zu bestimmen, und um eine Korrespondenz zwischen mindestens einem zyklischen Verhältnis des Spannungssignals (V), das vom Messmodul (MES) geliefert wird, und einer Anzeige eines Betriebsmodus festzusetzen.

2. Vorrichtung (2) nach Anspruch 1, **dadurch gekennzeichnet, dass** sie ein Kommunikationsmodul (COM) umfasst, das mit dem Steuermodul (CTRL) verbunden und konfiguriert ist, um die Anzeige der Betriebsmodus zu übertragen, z. B. an ein Kommunikationsmodul einer zentralen Station (44).

3. Vorrichtung (2) nach einem beliebigen der Ansprüche 1 bis 2, **dadurch gekennzeichnet, dass** sie ein Versorgungsmodul (ALIM) umfasst, das konfiguriert ist, um das Messmodul (MES), ein Steuermodul (CTRL) und/oder das Kommunikationsmodul (COM) mit einer bestimmten Spannung (VCC) zu versorgen, wobei das Versorgungsmodul (ALIM) angeordnet ist, um mit der Steckdose (6) und dem elektrischen Gerät (4) in Reihe verbunden zu sein.

4. Vorrichtung (2) nach Anspruch 3, **dadurch gekennzeichnet, dass** die Verbindungsmittel Folgendes umfassen:
- eine erste und zweite Eingangsklemme (8, 10), die angeordnet sind, um mit Klemmen (12, 14) der Steckdose (6) verbunden zu sein, vorzugsweise mit einer Phasenklemme (12) und mit einer neuralen Klemme (14); und
- eine erste und zweite Ausgangsklemme (16, 18), die angeordnet sind, um mit Klemmen (20, 22) des elektrischen Geräts (4) verbunden zu sein; und
dadurch, dass das Versorgungsmodul (ALIM) Folgendes umfasst:
- eine Leistungsstufe (26), die mit der ersten Eingangsklemme (8) und mit der ersten Ausgangsklemme (16) der Verbindungsmittel verbunden ist, um eine Potenzialdifferenz zwischen diesen Klemmen (8, 16) zu erzeugen, und versehen mit mindestens zwei Dioden (D26); und
- und eine kapazitive Gleichrichtungsstufe (28), die mit der ersten Eingangsklemme (8) und mit der ersten Ausgangsklemme (16) verbunden und mit mindestens einer Diode (D28) und einem Kondensator (C28) versehen ist.

5. Vorrichtung (2) nach Anspruch 4, **dadurch gekennzeichnet, dass** das Messmodul (MES) Folgendes umfasst:
- einen Stromdetektor wie z. B. einen Optokoppler, der einen Sender (D30) und einen Empfänger (T32) aufweist;
- eine Sendestufe (30), die mit der ersten Eingangsklemme (8) und der ersten Ausgangsklemme (16) der Verbindungsmittel verbunden ist,
wobei die Sendestufe (30) mit mindestens einem Widerstand (R30) und dem Sender (D30) des Stromdetektors versehen ist,
wobei der Sender (D30) des Stromdetektors entworfen ist, um nur zu senden, wenn der Strom (i'), der in der Sendestufe (30) fließt, größer als eine bestimmte Schwelle (S) ist; und
- eine Empfangsstufe (32), umfassend mindestens einen Widerstand (R32) und den Empfänger (T32) des Stromdetektors,
wobei der Empfänger (T32) des Stromdetektors angeordnet ist, um in einen Ein-Zustand zu schalten, wenn der Sender (D32) sendet, und um andernfalls in einen Aus-Zustand zu schalten.

6. Vorrichtung (2) nach Anspruch 4 und 5, **dadurch gekennzeichnet, dass** die Empfangsstufe (32) des Messmoduls (MES) mit dem Kondensator (C28) der kapazitiven Gleichrichtungsstufe (28) des Versorgungsmoduls (ALIM) parallel verbunden ist.

7. Vorrichtung (2) nach einem beliebigen der Ansprüche 1 bis 6, **dadurch gekennzeichnet, dass** sie Mittel zur unlösbaren Fixierung an das elektrische Gerät (4) umfasst.

8. Vorrichtung (2) nach einem beliebigen der Ansprüche 1 bis 7, **dadurch gekennzeichnet, dass** sie Mittel zur entfernbaren Fixierung an das elektrische Gerät (4) umfasst.

9. Einheit (40) zur Verwaltung von Betriebsdateien mindestens eines elektrischen Geräts (4), **dadurch gekennzeichnet, dass** es Folgendes umfasst:
- eine Vorrichtung (2) nach einem beliebigen der Ansprüche 2 bis 8, assoziiert mit dem elektrischen Gerät; und
- eine zentrale Station (44), umfassend:
- ein Kommunikationsmodul (46), das konfiguriert ist, um mit dem Kommunikationsmodul (COM) der Vorrichtung (2) zu kommunizieren und um mindestens eine Anzeige zu empfangen; und
- ein Steuermodul (48), das mit dem Kommunikationsmodul (46) verbunden und konfiguriert ist, um mindestens ein Betriebsdatum des elektrischen Geräts (4) ausgehend von der mindestens einen empfangenen Anzeige zu bestimmen.

10. Einheit (40) nach Anspruch 9, **dadurch gekennzeichnet, dass** das Kommunikationsmodul (46) der zentralen Station konfiguriert ist, um eine Alarmmeldung an ein Kommunikationsmodul einer peripheren Station (42) in Antwort auf ein bestimmtes Ereignis zu übertragen.

11. Verfahren zur Bestimmung eines Betriebsmodus eines elektrischen Geräts (4), **dadurch gekennzeichnet, dass** es die Schritte umfasst, bestehend aus:
- Liefern eines Rechteckspannungssignals (V), dessen zyklisches Verhältnis eine Funktion der Form des Stroms (i) ist, der zwischen einer Steckdose (6) und dem elektrischen Gerät (4) zirkuliert, und insbesondere der Geometrie und/oder der Amplitude des Stroms (i); und
- Bestimmen des zyklischen Verhältnisses des Spannungssignals (V) und Festsetzen einer Korrespondenz zwischen mindestens einem zyklischen Verhältnis des gelieferten Spannungssignals (V) und einer Anzeige des Betriebsmodus; und
- Liefern dieser Anzeige.

12. Verfahren nach Anspruch 11, **dadurch gekennzeichnet, dass** es einen Schritt umfasst, der darin besteht, definitiv oder provisorisch eine Einheit von zyklischen Verhältnissen und Anzeigen von entsprechenden Betriebsmodi zu speichern.

13. Verfahren nach Anspruch 12, **dadurch gekennzeichnet, dass** es die Schritte umfasst, die darin bestehen:
- eine Anfrage zur Speicherung einer Anzeige eines Betriebsmodus des elektrischen Geräts zu empfangen;
- den Betriebsmodus des elektrischen Geräts durchzuführen;
- ein Spannungssignal zu liefern, dessen zyklisches Verhältnis eine Funktion der Form des Stroms (i) ist, der zwischen dem elektrischen Gerät (4) und der Steckdose (6) zirkuliert; und
- eine Korrespondenz zwischen einer Anzeige des Betriebsmodus und dem zyklischen Verhältnis festzusetzen; und
- das zyklische Verhältnis und die Anzeige des entsprechenden Betriebsmodus zu speichern.

## Claims

1. A device (2) for determining an operating mode of an electrical apparatus (4), **characterized in that** it includes:
- connection means arranged to connect the electrical apparatus (4) to a main socket (6) so that a current (i) can flow between the main socket (6) and the electrical apparatus (4);
- a measuring module (MES) configured to provide a rectangular voltage signal (V) whose duty cycle is a function of the shape of the current (i) flowing between the main socket (6) and the electrical apparatus (4), and in particular of the geometry and/or the magnitude of the current (i); and
- a control module (CTRL) connected to the measuring module (MES) and configured to determine the duty cycle of the voltage signal (V) and establish a correspondence between at least one duty cycle of the voltage signal (V) provided by the measuring module (MES) and one indicator of an operating mode.

2. The device (2) according to claim 1, **characterized in that** it includes a communication module (COM) connected to the control module (CTRL) and configured to transmit the indicator of the operating mode, for example to a communication module of a central station (44).

3. The device (2) according to any one of claims 1 to 2, **characterized in that** it includes a power supply module (SUPP) configured to supply the measuring module (MES), the control module (CTRL) and/or the communication module (COM) with a determined voltage (VCC), the power supply module (SUPP) being arranged to be connected in series to the main socket (6) and the electrical apparatus (4).

4. The device (2) according to claim 3, **characterized in that** the connection means comprise:
- first and second input terminals (8, 10) arranged to be connected to terminals (12, 14) of the main socket (6), preferably to a phase terminal (12) and to a neutral terminal (14); and
- first and second output terminals (16, 18) arranged to be connected to terminals (20, 22) of the electrical apparatus (4); and
**in that** the power supply module (SUPP) comprises:
- a power stage (26) connected to the first input terminal (8) and to the first output terminal (16) of the connection means to create a potential difference between these terminals (8, 16) and provided with at least two diodes (D26); and
- a capacitive rectification stage (28) connected to the first input terminal (8) and to the first output terminal (16) and provided with at least one diode (D28) and one capacitor (C28).

5. The device (2) according to claim 4, **characterized in that** the measuring module (MES) comprises:
- a current detector, such as an optocoupler, having an emitter (D30) and a receiver (T32);
- an emission stage (30) connected to the first input terminal (8) and to the first output terminal (16) of the connection means,
the emission stage (30) being provided with at least one resistor (R30) and with the emitter (D30) of the current detector,
the emitter (D30) of the current detector being designed to emit only when the current (i') flowing in the emission stage (30) is greater than a determined threshold (S); and
- a receiving stage (32) comprising at least one resistor (R32) and the receiver (T32) of the current detector,
the receiver (T32) of the current detector being arranged to switch to an on-state when the emitter (D32) is emitting and to switch to an off-state otherwise.

6. The device (2) according to claims 4 and 5, **characterized in that** the receiving stage (32) of the measuring module (MES) is connected in parallel to the capacitor (C28) of the capacitive rectification stage (28) of the power supply module (SUPP).

7. The device (2) according to any one of claims 1 to 6, **characterized in that** it includes irremovable fixing means to the electrical apparatus (4).

8. The device (2) according to any one of claims 1 to 7, **characterized in that** it includes removable fixing means to the electrical apparatus (4).

9. A set (40) for managing operating data of at least one electrical apparatus (4), **characterized in that** it includes:
- a device (2) according to any one of claims 2 to 8 associated with said electrical apparatus; and
- a central station (44) comprising:
• a communication module (46) configured to communicate with the communication module (COM) of the device (2) and to receive at least one indicator; and
• a control module (48) connected to the communication module (46) and configured to determine at least one operating data of the electrical apparatus (4) from said at least one received indicator.

10. The set (40) according to claim 9, **characterized in that** the communication module (46) of the central station is configured to transmit an alert message to a communication module of a peripheral station (42) in response to a particular event.

11. A method for determining an operating mode of an electrical apparatus (4), **characterized in that** it includes the steps consisting in:
- providing a rectangular voltage signal (V) whose duty cycle is a function of the shape of a current (i) flowing between a main socket (6) and the electrical apparatus (4), and in particular of the geometry and/or magnitude of the current (i); and
- determining the duty cycle of the voltage signal (V) and establishing a correspondence between at least one duty cycle of the provided voltage signal (V) and one indicator of an operating mode; and
- providing this indicator.

12. The method according to claim 11, **characterized in that** it includes a step consisting in memorizing, definitively or provisionally, a set of duty cycles and corresponding indicators of operating modes.

13. The method according to claim 12, **characterized in that** it includes the steps consisting in:
- receiving a request for memorizing an indicator of an operating mode of the electrical apparatus;
- implementing the operating mode of the electrical apparatus;
- providing a voltage signal whose duty cycle is a function of the shape of the current (i) flowing between the electrical apparatus (4) and the main socket (6); and
- establishing a correspondence between an indicator of the operating mode and the duty cycle; and
- memorizing the duty cycle and the indicator of the corresponding operating mode.
